# EUROPEAN PATENT APPLICATION

(11) **EP 4 545 575 A1**
(43) Date of publication of application: **30.04.2025**
(21) Application number: 23866647.3
(22) Date of filing: 08.12.2023
(51) Int. Cl.: C08F 210/16

(54) **ETHYLENE/¿-OLEFIN COPOLYMER WITH HIGH LIGHT TRANSMITTANCE**

(30) Priority: 28.08.2023 CN 202311083589
(71) Applicant: Wanhua Chemical Group Co., Ltd., Yantai, Shandong 264000 (CN)
(72) Inventor: WANG, Xinyu, Yantai Shandong 264006 (CN); HUANG, Lingyan, Yantai Shandong 264006 (CN); TIAN, Qin, Yantai Shandong 264006 (CN); ZHANG, Jie, Yantai Shandong 264006 (CN); WANG, Lei, Yantai Shandong 264006 (CN); XIN, Shaohui, Yantai Shandong 264006 (CN); HE, Yong, Yantai Shandong 264006 (CN)
(74) Representative: HGF
(86) International application number: PCT/CN2023/137521
(87) International publication number: WO 2025/043951

(57) **Abstract**

The present application relates to an ethylene/α-olefin copolymer with high light transmittance, which meets conditions (a) to (d) below: (a) a density is 0.855-0.885 g/cm³; (b) a molecular weight distribution is 1.8-3.2; (c) a melt index is 0.3-40 g/10min at 190 °C and a load of 2.16 kg; and (d) an ethylene ternary sequence EEE has a proportion of less than 70%, and EXE+XEX has a proportion of more than 10%, calculated through high-temperature ¹³C nuclear magnetic resonance spectra (¹³C-NMR); wherein E represents an ethylene unit, and X represents an α-olefin unit. The ethylene/α-olefin copolymer of the present application has a low glass transition temperature and high light transmittance, which can be used as a photovoltaic packaging material.

## Description

### TECHNICAL FIELD

The present application relates to an ethylene/α-olefin copolymer with a low glass transition temperature and a high light transmittance and a preparation method therefor.

### BACKGROUND

Influenced by factors such as global warming and the continuous consumption of non-renewable energy, the global energy consumption is transforming into a low-carbon pathway quickly. Photovoltaic power generation is clean and sustainable and has become an important new energy development direction, emerging rapidly in various countries and regions around the world. With an increasing market share of the double-glass battery and the N-type battery, the demand for polyolefin elastomer particles is growing rapidly. Polyolefin elastomer (POE), a thermoplastic elastomer obtained by in-situ polymerizing ethylene and α-olefin with a metallocene catalyst or a non-metallocene catalyst, has an excellent water vapor barrier ability, weather resistance, and high volume resistivity and ensures the safety and long-term aging resistance of photovoltaic modules operating in a high-temperature and high-humidity environment, which has been widely used as packaging film materials for photovoltaic modules.

The continuous improvement of the power generation efficiency of the photovoltaic modules requires not only more advanced battery technologies but also auxiliary materials having better encapsulation performance and aging resistance in the module. The polyolefin elastomer is used as a packaging material in the module, and the power generation of the cell is directly determined by the amount of sunlight passing through the packaging material and being absorbed by the cell, so the light transmittance is a key performance of the packaging material. For polymer materials, the light transmittance is closely related to crystal properties, and it is a very important subject to improve the light transmittance of polymers as much as possible while other properties such as volume resistivity and yellowness are ensured to meet the requirements. Meanwhile, various small molecule additives are required to be added in the packaging material when processed into the packaging film in the subsequent stage, and the small molecule additives are very easy to be decomposed in the later stage, which further affects the light transmittance of the film. Therefore, it is necessary to develop a polyolefin elastomer with a high light transmittance at polymer particle side to improve the power generation performance of modules.

### SUMMARY

An object of the present application is to provide an ethylene/α-olefin copolymer with a low glass transition temperature and high light transmittance, which is suitable for packaging film materials of photovoltaic modules.

To achieve the above object, the present application adopts the technical solutions below.

An ethylene/α-olefin copolymer is provided, which meets conditions (a) to (d) below:
(a) a density is 0.855-0.885 g/cm³;
(b) a molecular weight distribution is 1.8-3.2;
(c) a melt index is 0.3-40 g/10min at 190°C and a load of 2.16 kg; and
(d) an ethylene ternary sequence EEE has a proportion of less than 70%, and EXE+XEX has a proportion of more than 10%, calculated through ¹³C nuclear magnetic resonance spectra (¹³C-NMR);
in the condition (d), E represents an ethylene unit, and X represents an α-olefin unit.

In the present application, preferably, the ethylene/α-olefin copolymer has a melt index of 0.5-30 g/10min.

In the present application, preferably, in the ethylene/α-olefin copolymer, the ethylene ternary sequence EEE has a proportion of 60.3-69.5%, the EXE has a proportion of 9.5-11.8%, and the XEX has a proportion of 1.2-1.82%.

In the present application, preferably, in the ethylene/α-olefin copolymer, the ethylene ternary sequence EEE has a proportion of 63.5-69.5%, the EXE has a proportion of 9.5-11.8%, and the XEX has a proportion of 1.2-1.8%.

In the present application, the ethylene/α-olefin copolymer has a melt temperature of less than or equal to 75 °C. Specifically, the melt temperature can be more than or equal to 50 °C, more than or equal to 55 °C, or more than or equal to 60 °C, and can be less than or equal to 70 °C, less than or equal to 68 °C, or less than or equal to 65 °C.

In the present application, the ethylene/α-olefin copolymer has a glass transition temperature (T_{g}) of less than or equal to -45 °C. Specifically, the glass transition temperature can be less than or equal to -50°C, less than or equal to -55°C, or less than or equal to -60°C.

In the present application, the ethylene/α-olefin copolymer has a weight average molecular mass M_{w} of 40000-150000 g/mol. Specifically, the weight average molecular mass can be more than or equal to 45000 g/mol, more than or equal to 60000 g/mol, or more than or equal to 70000 g/mol, and can be less than or equal to 150000 g/mol, or less than or equal to 80000 g/mol.

In the present application, the ethylene/α-olefin copolymer has a number average molecular mass Mₙ of 20000-80000 g/mol. Specifically, the number average molecular mass can be more than or equal to 25000 g/mol, more than or equal to 30000 g/mol, or more than or equal to 40000 g/mol, and can be less than or equal to 80000 g/mol, less than or equal to 60000 g/mol, or less than or equal to 50000 g/mol.

The weight average molecular mass (M_{w}) and the number average molecular mass (Mₙ) are calculated based on the molecular mass of polystyrene by gel permeation chromatography (GPC) analysis, and the molecular weight distribution can be calculated from the ratio of M_{w}/Mₙ.

In the present application, the α-olefin of the ethylene/α-olefin copolymer is an olefin having 3-20 carbon atoms, which comprises one or more of propylene, 1-butene, 1-pentene, 4-methyl-1-pentene, 1-hexene, 1-heptene, 1-octene, 1-decene, 1-undecene, 1-dodecene, 1-tetradecene, 1-hexadecene, and 1-eicosene.

In the present application, an α-olefin comonomer of the ethylene/α-olefin copolymer has a molar incorporation ratio of 5-50%. Specifically, the molar incorporation ratio can be more than or equal to 10%, more than or equal to 15%, or more than or equal to 20%, and can be less than or equal to 50%, less than or equal to 45%, or less than or equal to 40%.

The present application also relates to a preparation method for the aforementioned ethylene/α-olefin copolymer.

The preparation method for the ethylene/α-olefin copolymer of the present application comprises: polymerizing ethylene and α-olefin in the presence of a catalyst composition containing a compound A and a compound B;
the preparation of the ethylene/α-olefin copolymer of the present application comprises using transition metal compounds represented by the compound A and compound B as catalysts. The compounds represented by the compound A and compound B have different polymerization activity on α-olefin monomers and have different temperature resistance, so in a case where a mixture of compound A and compound B are used, process parameters can be adjusted according to the needs to develop different copolymers;
in the present application, a molar ratio of the transition metal compounds represented by the compound A and the compound B can be 1:1 to 1:10, such as 1:1.5 to 1:9, 1:2 to 1:5, or 1:2 to 1:4, but the molar ratio is not limited thereto. The total amount of the catalysts can be determined by a skilled in the art according to the catalyst activity and the weight of the target product.

It is found by studies that the copolymer with excellent light transmittance can be prepared by regulation through three methods below: firstly, the transition metal compound A and the transition metal compound B with different copolymerization ability for the comonomer are used; secondly, a flow rate ratio of the ethylene and the comonomer and a flow rate ratio of the mixed transition metal compounds are adjusted for several times to make the incorporation ratio of the comonomer more uniform; thirdly, in a case where a plurality of comonomers are used simultaneously for polymerization, and a flow rate ratio of different comonomers is controlled, the damage degrees of different comonomers to ethylene crystal segments are different. In the present application, the copolymer with excellent transmittance performance is prepared by comprehensively use of the above three methods.

In the present application, in order to enable the compound A and/or the compound B to have a high polymerization activity, a cocatalyst is preferably used in the catalyst composition, and the cocatalyst can be divided into two categories: alkyl aluminum compounds or alkyl aluminoxane compounds, and borate-salt compounds. Specifically, the alkyl aluminum compounds or alkyl aluminoxane compounds comprise trimethyl aluminum, triethyl aluminum, triisobutyl aluminum, tripropyl aluminum, tributyl aluminum, methylaluminoxane (MAO), modified methylaluminoxane (MMAO), ethylaluminoxane, isobutylaluminoxane, or tert-butyl aluminoxane, etc.; the borate-salt compounds comprise tri-substituted ammonium-type borate salt compounds such as trimethylammonium tetraphenylborate, methylbisoctadecylammonium tetraphenylborate, triethylammonium tetraphenylborate, tripropylammonium tetraphenylborate, tri(n-butyl)ammonium tetraphenylborate, methyltetradecyloctadecylammonium tetraphenyl borate, N,N-dimethylphenylammonium tetraphenylborate, N,N-diethylphenylammonium tetraphenylborate, N,N-dimethyl(2,4,6-trimethylphenylammonium)tetraphenylborate, trimethyl ammonium tetrakis(pentafluorophenyl)borate, methylbistetradecylammonium tetrakis(penta fluorophenyl) borate, methyl bisoctadecylammonium tetrakis(pentafluorophenyl)borate, triethylammonium tetrakis(pentafluorophenyl)borate, tripropylammonium tetrakis(pentafluoro phenyl)borate, tri(n-butyl)ammonium tetrakis(pentafluorophenyl)borate, tri(sec-butyl)ammonium tetrakis(pentafluorophenyl)borate, N,N-dimethylphenylammonium tetrakis(pentafluorophenyl)borate, N,N-diethylphenylammonium tetra(pentafluorophenyl) borate, N,N-dimethyl(2,4,6-trimethylphenylammonium) tetrakis(pentafluorophenyl)borate, trimethylammonium tetra(2,3,4,6-tetrafluorophenyl)borate, triethylammonium tetra (2,3,4,6-tetrafluorophenyl)borate, tripropylammonium tetra(2,3,4,6-tetrafluorophenyl) borate, tri(n-butyl)ammonium tetra(2,3,4,6-tetrafluorophenyl)borate, dimethyl(tert-butyl)ammonium tetra(2,3,4,6-tetrafluorophenyl)borate, N,N-dimethylphenyl ammonium tetra(2,3,4,6-tetrafluoro phenyl)borate, N,N-diethylphenylammonium tetra(2,3,4,6-tetrafluorophenyl)borate or N,N-dimethyl-(2,4,6-trimethylphenylammonium) tetra-(2,3,4,6-tetrafluorophenyl)borate, dialkylammonium-type borate salt compounds such as bisoctadecylammonium tetrakis(pentafluorophenyl)borate, bistetradecylammonium tetrakis(pentafluorophenyl)borate or dicyclohexylammonium tetra(pentafluorophenyl) borate, and tri-substituted phosphate-type borate salt compounds such as triphenyl phosphonium tetrakis(pentafluorophenyl)borate, methyl bisoctadecyl phosphonium tetra(pentafluorophenyl) borate or tri(2,6-dimethylphenyl) phosphonium tetra(pentafluorophenyl) borate, but the cocatalyst is not limited thereto;
the ethylene/α-olefin copolymer prepared by using appropriate amount of these cocatalysts has a more uniform molecular weight distribution and higher polymerization activity. In some embodiments, a ratio of the feed speed of the cocatalyst to the feed speed of the catalyst is 5-1000, preferably 10-100, a molar ratio of metals.

In the present application, under the condition of the catalyst composition, the polymerization reaction is inhibited by introducing 1-80 cm⁻³/min of hydrogen continuously. Specifically, an introducing amount of the hydrogen is more than or equal to 1 cm⁻³/min, more than or equal to 5 cm⁻³/min, more than or equal to 10 cm⁻³/min, more than or equal to 20 cm⁻³/min, or more than or equal to 30 cm⁻³/min, and less than or equal to 80 cm⁻³/min, less than or equal to 60 cm⁻³/min, less than or equal to 50 cm⁻³/min, or less than or equal to 40 cm⁻³/min.

In the present application, the polymerization reaction can be performed at a temperature of 100-200 °C to ensure that the catalyst composition keeps a high polymerization activity at a suitable temperature. Specifically, the polymerization reaction can be performed at the temperature of 100 °C, 120 °C, 140 °C, 160 °C, 180 °C, or 200 °C, but the temperature is not limited thereto.

In the present application, the polymerization reaction can be performed at a pressure of 1-7 Mpa to ensure that the catalyst composition keeps a high polymerization activity under a suitable pressure. Specifically, the polymerization reaction can be performed at the pressure of 1 Mpa, 3 Mpa, 5 Mpa, 6 Mpa, or 7 Mpa, but the pressure is not limited thereto.

In the present application, the compound A is further described in the Chinese patent CN111484574A, incorporated into the present application by reference, and has a structure represented by Formula I below: 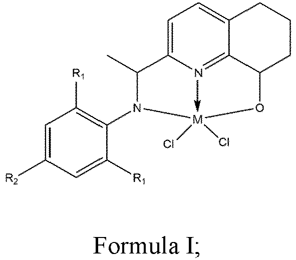
in the Formula I, R₁ and R₂ are the same or different, and are each independently selected from hydrogen, methyl, isopropyl, or tert-butyl; preferably, R₁ is selected from methyl, isopropyl, or tert-butyl; R₂ is selected from hydrogen, methyl, or tert-butyl; M is selected from titanium, zirconium, or hafnium, and preferably, M is zirconium;
preferably, the compound A in the present application has the following structure: 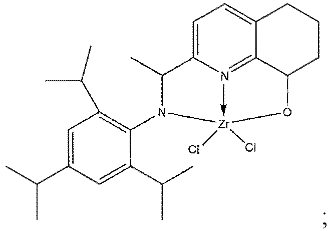
the compound B is further described in Chinese patent CN111909196B, incorporated into the present application by reference, and has a structure represented by Formula II below: 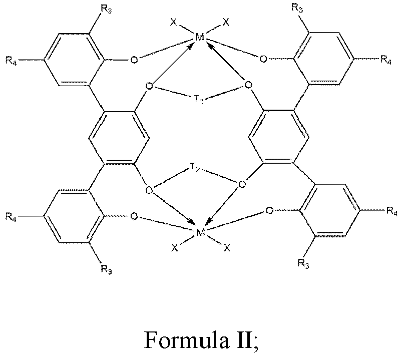
in the Formula II, R₃ is selected from any one of the following groups: C3-10 cycloalkyl, C3-10 cycloalkyloxyl, C3-10 dicycloalkylamino, C6-14 aryl, C6-14 aryloxyl, C6-14 arylamino, dicyclohexylmethyl, dibenzocycloheptyl, anthryl, or dicyclohexanophenyl; R₄ is selected from hydrogen, halogen, or any one of the following groups: C1-6 alkyl, C1-6 alkoxy, C3-10 cycloalkyl, C3-10 cycloalkyloxyl, C6-14 aryl, or C6-14 aryloxyl; T1 and T2 are the same or different, and each are 1,2-ethylene, 1,3-propylene, 1,4-butylene, or 2,4-pentylene; X is halogen, methyl, benzyl, or dimethylamino; M is selected from titanium, zirconium, or hafnium, and preferably, M is zirconium;
preferably, the compound B in the present application has the following structure: 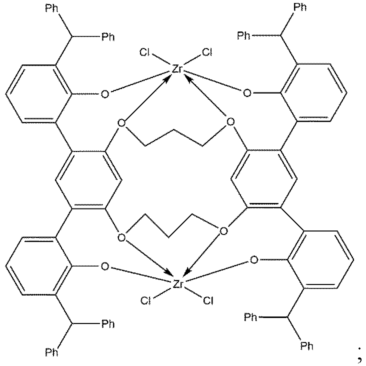
a molecular chain of the ethylene/α-olefin copolymer prepared by using these mixed compounds as a catalyst in the present application is incorporated with a large number of α-olefin comonomers, and the α-olefin comonomers are located in high-density regions similar to a polyethylene segment and also between ethylene monomers in large quantities, and such distribution destroys the crystallization of the polyethylene segments, so that the lamellar crystals of the copolymer are reduced in size and are more uniform, and the light transmittance performance of the copolymer is more excellent.

In general, when two or more non-polar monomers are polymerized through solution polymerization method, the molecular weight distribution will be broadened, which is beneficial for the processability of the polymer, but partial mechanical performance will be lost at the same time. The molecular weight distribution is affected by the copolymerization performance of the catalyst for different monomers, and when two or more catalysts are used to prepare copolymers, if the polymerization performances of each catalyst are quite different, the molecular weight distribution of the polymer will be broadened;

in order to control the molecular mass of the polymer and maintain good processability of the polymer, during the polymer reaction, it is necessary to introduce a certain amount of hydrogen at an appropriate time to prevent the polymer chain from β-hydrogen elimination reaction and terminate the polymerization reaction. In this case, the molecular mass of the polymer is decreased accordingly and the melt index is increased accordingly. Therefore, an appropriate type of the catalyst and an appropriate amount of the hydrogen introduced are required to be determined within a scope of satisfying the inherent characteristics of molecular mass and molecular weight distribution, which are affected by the catalyst structure, and the reduction effect of the molecular mass based on the hydrogen introduction simultaneously.

Generally, if the crystallinity of the copolymer is high, the light transmittance is decreased and the glass transition temperature is increased due to the increase of high crystal content. Conversely, the size distribution index of the copolymer lamellar crystals in the present application is narrower, and the distribution of the lamellar crystals is more uniform, and therefore, the copolymer has excellent light transmittance and low-temperature resistance.

The present application further relates to an application of the above ethylene/α-olefin copolymer.

The ethylene/α-olefin copolymer of the present application can form a resin composition with a crosslinking agent, an assistant crosslinker, a silane coupling agent, a light stabilizer, an ultraviolet absorber, an anti-bleeding agent, an anti-PID additive, and other agents. In addition to the above components, various additives commonly known in the art can be further appropriately comprised in the resin composition according to the use.

In addition, the above resin composition can be used to prepare a photovoltaic packaging material by a molding method such as casting extrusion and double-screw extrusion, and for example, the resin composition is used to prepare a packaging film for photovoltaic modules, which guarantees the long-term stable power generation performance of the cell.

The present application has the following beneficial effects.

The ethylene/α-olefin copolymer of the present application has a EEE ternary structure in low proportion and a more uniform distribution of the α-olefin. Due to the uniform incorporation of the α-olefin, the damage of the ethylene crystal segment is increased, and the crystallization performance of the polymer is weakened, so that the copolymer has a thinner thickness of the lamellar crystals, a size distribution index of the lamellar crystals is narrower, and a distribution of the lamellar crystals is more uniform. Therefore, the copolymer has a lower crystallinity. The polymer with a low crystallinity has a higher transparency, which can improve the intensity of the incident sunlight on the surface of the cell when used in the photovoltaic packaging film, thereby improving the power generation efficiency of the cell. At the same time, the glass transition temperature of the polymer with a low crystallinity is low, and the product can still maintain excellent deformation resistance at a lower temperature, ensuring that the battery module can be used for a long time in a colder environment.

### DETAILED DESCRIPTION

The technical solutions in examples of the present application are clearly and completely described below, and obviously, the examples described are only a part of examples of the present application but not all examples. Based on the examples in the present application, all other examples obtained by a person skilled in the art without creative efforts shall fall within the protection scope of the present application.

Catalysts used in examples and comparative examples: 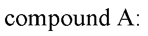 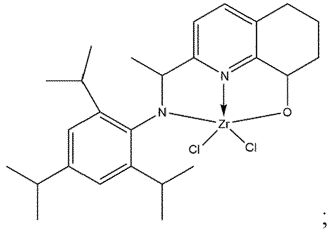 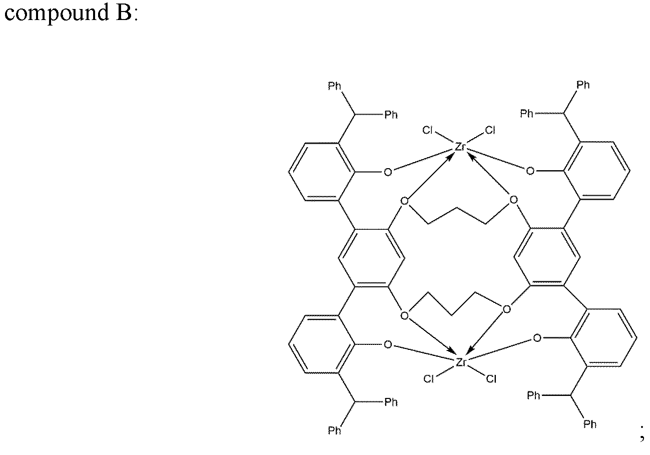 and modified methylaluminoxane (MMAO): with a concentration of 7 wt% Al in Isopar E solvent, from Nouryon Chemicals (Ningbo) Co., Ltd.

### Example 1

A solution polymerization reaction was performed in a 10 L continuous tank reactor, and materials were charged from the bottom and discharged from the upper port. A feed amount of solvent Isopar E was 40 kg/h, and comonomers (octene, hexene, and butene) and ethylene were deoxidized and dehydrated in a fixed bed, and then continuously fed into the tank reactor according to a feed rate shown in Table 1. Catalysts and a cocatalyst MMAO were prepared into a solution, and then fed into the tank reactor according to a feed rate shown in Table 1, and the catalyst concentration was 400 ppm (dissolved in the solvent Isopar E). The reaction was controlled to be performed at a specified temperature by a heat exchanger in front of the tank reactor and a jacket of the reactor, and the pressure was controlled by a pneumatic proportional control valve at the discharge port of the tank reactor;
a melt after the polymerization reaction was devolatilized and granulated, and then sampled for analysis;
other parameters are shown in Table 1;
copolymers with different performances were obtained in Examples 2-4 by changing parameters such as the type of incorporated comonomers, the flow rate ratio, and the feed amount of the catalysts, and the parameters are shown in Table 1;
the unit of the flow rate of the catalysts is µmol·min⁻¹, and the unit of the flow rate of the cocatalyst is mmol·min⁻¹.

### Comparative Examples 1-4

The copolymer was prepared by basically the same method, solution polymerization, as in the examples, and the difference is that the process parameters were adjusted, wherein rac-ethylene bis(1-indenyl) zirconium dichloride (denoted as catalyst C), 99%.

**Table 1 Partial materials and partial process parameters in Examples 1-4 and Comparative Examples 1-4**

| | Catal yst type | Molar ratio | Cat. | Cocat alyst | C2 /kg·h⁻¹ | C4 /kg·h⁻¹ | C6 /kg·h⁻¹ | C8 /kg·h⁻¹ | Hydro gen /cm⁻³ /min | Polym erizati on tempe rature /°C | Polym erizati on pressu re /Mpa |
|---|---|---|---|---|---|---|---|---|---|---|---|
| Example 1 | A+B | 1:1 | 0.235 | 0.016 5 | 5.5 | 5.2 | / | / | 8 | 180 | 4 |
| Example 2 | A+B | 3:7 | 0.275 | 0.019 3 | 5.7 | / | / | 7.4 | 9 | 165 | 5 |
| Example 3 | A+B | 1:1 | 0.266 | 0.018 6 | 6.3 | 4.3 | / | 5.5 | 12 | 180 | 3 |
| Example 4 | A+B | 3:7 | 0.275 | 0.019 3 | 6.5 | 3.1 | 3.4 | / | 11 | 165 | 4 |
| Comparativ e Example 1 | A | / | 0.266 | 0.018 6 | 5.5 | 5.2 | / | / | 10 | 180 | 3 |
| Comparativ e Example 2 | B | / | 0.194 | 0.028 3 | 5.7 | / | / | 7.4 | 13 | 180 | 6 |
| Comparativ e Example 3 | C | / | 0.283 | 0.031 4 | 6.0 | / | 3.5 | 4.6 | 15 | 140 | 6 |
| Comparativ e Example 4 | A+B | 1:1 | 0.241 | 0.017 9 | 4.3 | 3.1 | / | 3.3 | 9 | 190 | 5 |

| | | | | | | | | | | | |
|---|---|---|---|---|---|---|---|---|---|---|---|
| Note: C2, C4, C6, and C8 represent ethylene, butene, hexane, and octene, respectively; the feed rate of the catalyst is measured by metal. | | | | | | | | | | | |

Performance characterization of the ethylene/α-olefin copolymer:
The performance of the ethylene/α-olefin copolymer prepared in examples and comparative examples were tested by the following methods, and the results are shown in Table 2.
(1) Density (g/cm³) was tested according to ASTM D-792.
(2) Melt index (g/10min) was tested according to ASTM D-1238 (under the condition of 190°C and a load of 2.16 Kg).
(3) Glass transition temperature (°C) can be determined with a differential scanning calorimeter manufactured by PerkinElmer (DSC 6000). Specifically, the temperature of the copolymer was raised to 150°C and hold for 5 min with DSC in a nitrogen atmosphere, and reduced to -100°C, then the temperature was raised again, and a DSC curve was observed. At this time, the heating rate and the cooling rate were 10°C/min, respectively.
(4) Molecular mass (M_{w}), molecular weight distribution (MWD) and comonomer incorporation ratio can be determined by gel permeation chromatography (GPC). Specifically, the chromatographic column was Agilent Olexis; the solvent was trichlorobenzene; the flow rate was 1.0 mL/min; the sample concentration was 1.0 mg/mL; the injection volume was 200 µL; the temperature of the chromatographic column was 160 °C; the detector was Agilent High Temperature RI Detector; and the standard was polystyrene (corrected with a cubic function).
(5) Comonomer distribution can be determined through ¹³C NMR. Specifically, 2.74 g of the sample and tetrachloroethane-d₂ containing 0.025 M of Cr(AcAc)₃ were added into an NoreII1001-7 10 mm NMR tube. The tube was purged manually with nitrogen for 1 min to remove oxygen by using a Pasteur pipette. In a case where a heating plate was used while a heat gun was avoided as much as possible, the tube and its contents were heated to ~150 °C such that the sample was dissolved and homogenized. Before the analysis, the sample was thoroughly mixed and should not be cooled down before being inserted into a heated NMR probe, which was necessary to ensure that the sample was uniform and could represent the whole sample. Data was collected with a Bruker 400 MHz spectrometer equipped with a Bruker freezing probe. Data was collected by using 160 scans and a 6-second pulse repetition delay at a sample temperature of 120 °C. All tests were performed on a non-spin sample in a lock-on mode. The sample was subjected to heat balance for 7 min, and then data were collected. ¹³C NMR: the absorption peak of the ternary sequence segment EEE is at the chemical shift of 30.0 ppm, for the butene comonomer, absorption peaks of the ternary sequence segment EBE are at the chemical shifts of 39.7 ppm, 26.7 ppm, and 11.2 ppm, and the absorption peak of the ternary sequence segment BEB is at the chemical shift of 34.7 ppm; for the hexene comonomer, absorption peaks of the ternary sequence segment EHE are at the chemical shifts of 38.1 ppm, 34.1 ppm, 29.5 ppm, 23.4 ppm, and 14.1 ppm, and the absorption peak of the ternary sequence segment HEH is at the chemical shift of 35.0 ppm; for the octene comonomer, absorption peaks of the ternary sequence segment EOE are at the chemical shifts of 38.5 ppm, 32.4 ppm, 22.9 ppm, and 14.1 ppm, and the absorption peak of the ternary sequence segment OEO is at the chemical shift at 35.1 ppm. The total proportion of the ternary sequences EBE, EHE, and EOE in the molecular chain is taken as a proportion of EXE, and the total proportion of the ternary sequences BEB, HEH, and OEO in the molecular chain is taken as a proportion of XEX.

**Table 2 Performance of the ethylene/α-olefin copolymers prepared in Examples 1-4 and Comparative Examples 1-4**

| | Dens ity | Melt index | T_{g} | Tₘ | M_{w} | MW D | Monom er incorpo ration ratio | Activity | EEE | EXE | XEX |
|---|---|---|---|---|---|---|---|---|---|---|---|
| | g/cm ³ | g/10mi n | °C | °C | 10⁴g· mol⁻¹ | / | mol% | 10⁸g/mo 1 Cat·h⁻¹ | % | % | % |
| Example 1 | 0.87 0 | 14.8 | -58 | 67 | 5.4 | 2.15 | 13.7 | 2.3 | 63.6 | 9.6 | 1.57 |
| Example 2 | 0.86 6 | 13.9 | -60 | 64 | 5.2 | 2.36 | 15.8 | 1.4 | 62.5 | 10.5 | 1.66 |
| Example 3 | 0.86 9 | 12.4 | -65 | 62 | 5.3 | 2.25 | 14.6 | 5.7 | 60.3 | 11.3 | 1.82 |
| Example 4 | 0.87 1 | 14.1 | -56 | 70 | 5.1 | 2.43 | 12.7 | 3.8 | 65.6 | 9.5 | 1.48 |
| Compara tive Example 1 | 0.87 4 | 13.4 | -51 | 78 | 5.6 | 2.35 | 11.4 | 0.45 | 71.2 | 8.2 | 1.16 |
| Compara tive Example 2 | 0.86 9 | 13.9 | -50 | 73 | 5.4 | 2.06 | 11.9 | 0.89 | 70.9 | 8.4 | 1.17 |
| Compara tive Example 3 | 0.87 5 | 15.2 | -48 | 76 | 5.0 | 2.23 | 11.5 | 0.34 | 71.4 | 8.1 | 1.15 |
| Compara tive Example 4 | 0.87 9 | 14.8 | -62 | 73 | 5.7 | 3.35 | 13.8 | 2.5 | 72.3 | 10.9 | 1.52 |

### Preparation of packaging film

A certain amount of the ethylene/α-olefin copolymers obtained in examples and comparative examples were weighed out, fully mixed with a crosslinking agent, an assistant crosslinker, a silane coupling agent, a light stabilizer, an ultraviolet absorber, an antioxidant, and an anti-PID additive, and then added into a single screw casting extruder. The mixed material was melted and plasticized, then injected into a T-shaped die head, and subjected to melt extrusion, casting film formation, cooling, cutting, and winding to prepare a photovoltaic packaging film. The components of the packaging film are shown in Table 3.

**Table 3 Components and dosages for packaging film preparation**

| Formula | Component | Dosage/ part by weight |
|---|---|---|
| Resin | Ethylene/α-olefin copolymer | 100 |
| Crosslinking agent | Tert-butyl peroxy-2-ethylhexyl carbonate | 0.9 |
| Assistant crosslinker | Triallyl isocyanurate | 0.6 |
| Silane coupling agent | 3-(methacryloxy) propyl trimethoxysilane | 0.2 |
| Light stabilizer | Bis(2,2,6,6-tetramethyl-4-piperidyl)sebacate | 0.1 |
| Antioxidant | n-Octadecyl- β -(3,5-di-tert-butyl-4-hydroxyphenyl)propanoate | 0.1 |
| Ultraviolet absorber | 2-(2'-hydroxy-5'-methylphenyl)-benzotriazole | 0.1 |
| Anti-PID additive | Ethoxylated trimethylol propane triacrylate | 0.1 |

According to the spectrophotometer method of GB/T 2410-2008, the light transmittance test was performed, and average values of wavelength ranges of 290-380 nm and 380-1100 nm were calculated, respectively. The results are shown in Table 4.

**Table 4 Light transmittance of packaging films prepared in Examples 1-4 and Comparative Examples 1-4**

| Light transmitta nce | Exam ple 1 | Exam ple 2 | Exam ple 3 | Exam ple 4 | Compara tive example 1 | Compara tive example 2 | Compara tive example 3 | Compara tive example 4 |
|---|---|---|---|---|---|---|---|---|
| 290-380 nm | 89.98 | 90.36 | 90.56 | 89.76 | 86.32 | 84.21 | 85.52 | 83.95 |
| 380-1100 nm | 92.83 | 93.47 | 93.89 | 92.64 | 90.56 | 89.36 | 90.38 | 88.41 |

It can be seen from the results that the light transmittance is closely related to the comonomer incorporation ratio and the proportion of ternary sequence monomers. In the present application, the preparation of ethylene-α olefin is controlled by a variety of means, so that the polymer has a high light transmittance performance, and can meet the needs of the photovoltaic modules to maintain a high power generation efficiency.

## Claims

1. An ethylene/α-olefin copolymer, comprising an ethylene ternary sequence EEE by a proportion of less than 70%, and EXE+XEX by a proportion of more than 10%, calculated through ¹³C nuclear magnetic resonance spectra;
wherein E represents an ethylene unit, and X represents an α-olefin unit.

2. The ethylene/α-olefin copolymer according to claim 1, wherein the ethylene ternary sequence EEE has a proportion of 63.5-69.5%, the EXE has a proportion of 9.5-11.8%, and the XEX has a proportion of 1.2-1.8%.

3. The ethylene/α-olefin copolymer according to claim 1 or 2, wherein the ethylene ternary sequence EEE has a proportion of 60.3-69.5%, the EXE has a proportion of 9.5-11.8%, and the XEX has a proportion of 1.2-1.82%.

4. The ethylene/α-olefin copolymer according to any one of claims 1-3, which further meets conditions below:
(a) a density of 0.855-0.885 g/cm³;
(b) a molecular weight distribution of 1.8-3.2; and
(c) a melt index of 0.3-40 g/10min and preferably 0.5-30 g/10min at 190 °C and a load of 2.16 kg.

5. The ethylene/α-olefin copolymer according to any one of claims 1-4, wherein the ethylene/α-olefin copolymer has a melt temperature of less than or equal to 75 °C.

6. The ethylene/α-olefin copolymer according to any one of claims 1-5, wherein the ethylene/α-olefin copolymer has a glass transition temperature of less than or equal to -45 °C.

7. The ethylene/α-olefin copolymer according to any one of claims 1-6, wherein the ethylene/α-olefin copolymer has a weight average molecular mass M_{w} of 40000-150000 g/mol.

8. The ethylene/α-olefin copolymer according to any one of claims 1-7, wherein the ethylene/α-olefin copolymer has a number average molecular mass Mₙ of 20000-80000 g/mol.

9. The ethylene/α-olefin copolymer according to any one of claims 1-8, wherein the α-olefin is an olefin having 3-20 carbon atoms.

10. The ethylene/α-olefin copolymer according to any one of claims 1-9, wherein the α-olefin comprises at least one of propylene, 1-butene, 1-pentene, 4-methyl-1-pentene, 1-hexene, 1-heptene, 1-octene, 1-decene, 1-undecene, 1-dodecene, 1-tetradecene, 1-hexadecene, and 1-eicosene.

11. The ethylene/α-olefin copolymer according to any one of claims 1-10, wherein an α-olefin comonomer has a molar incorporation ratio of 5-50%.

12. The ethylene/α-olefin copolymer according to any one of claims 1-11, wherein the α-olefin comonomer has a molar incorporation ratio of 10-20%.

13. A photovoltaic packaging material, which comprises the ethylene/α-olefin copolymer according to any one of claims 1-12.
